**Europäisches Patentamt**

**European Patent Office**

**Office européen des brevets**

(19)

(11) Numéro de publication: **0 216 699**
**B1**

## FASCICULE DE BREVET EUROPEEN

(12)

(45) Date de publication du fascicule du brevet:
**16.08.90**

(51) Int. Cl.⁵: **H01L 23/66**

(21) Numéro de dépôt: **86402026.8**

(22) Date de dépôt: **16.09.86**

(54) Circuit hyperfréquence à faibles capacités parasites.

(30) Priorité: **20.09.85 FR 8513952**

(43) Date de publication de la demande:
**01.04.87 Bulletin 87/14**

(45) Mention de la délivrance du brevet:
**16.08.90 Bulletin 90/33**

(84) Etats contractants désignés:
**DE GB IT NL**

(56) Documents cités:
**FR-A- 2 514 562**
**GB-A- 2 118 371**

(73) Titulaire: **THOMSON-CSF, 51, Esplanade du Général de Gaulle, F-92800 Puteaux(FR)**

(72) Inventeur: **Bert, Alain, THOMSON-CSF SCPI 19, avenue de Messine, F-75008 Paris(FR)**
Inventeur: **Malbe, Serge, THOMSON-CSF SCPI 19, avenue de Messine, F-75008 Paris(FR)**

(74) Mandataire: **Taboureau, James et al, THOMSON-CSF SCPI, F-92045 Paris La Défense Cédex 67(FR)**

ACTORUM AG

## Description

La présente invention concerne un circuit hyperfréquence amélioré par diminution des capacités parasites qui se forment entre métallisations portées par les deux faces principales du substrat du circuit. Sont concernés par l'invention les circuits hyperfréquences réalisés sous forme hybride, sur un substrat constitué par une plaquette de céramique, aussi bien que ceux réalisés sous forme intégrée, sur un substrat constitué par une pastille de matériau semiconducteur rendu semi-isolant, tel que le GaAs par exemple.

Tous les circuits hyperfréquences comportent, quels que soient les fonctions qu'ils remplissent, un certain nombre d'éléments communs. Ils sont réalisés sur un substrat en matériau diélectrique, qui comporte sur une première face principale des composants actifs -diodes, transistors, circuits intégrés-, des pistes conductrices sous forme de microbandes, ou micro-strips en anglais, et des métallisations qui servent de relais de cablage ou de plot d'ajustage d'impédance par exemple. Les composants actifs sont fixés sur le substrat par l'intermédiaire de plages métallisées. Par ailleurs, la seconde face principale du substrat est totalement métallisée, de façon à former un premier plan de masse pour le circuit hyperfréquence. Cette métallisation est par ailleurs nécessaire pour générer des lignes d'impédance fixée constituées par une microbande parallèle à un plan de masse et séparé de lui par un diélectrique. Elle sert enfin à fixer le circuit hyperfréquence sur un support ou boitier métallique qui constitue également un second plan de masse.

Par contre, les plages de métallisations -autres que les microbandes- et les plots métallisés forment avec le plan de masse des capacités parasites, dont le substrat constitue le diélectrique. Ces capacités parasites sont de valeurs négligeables en statique, ou en courant continu, mais sont inacceptables en hyperfréquences, puisqu'elles désaccordent le circuit.

L'invention tend à diminuer considérablement la valeur de ces capacités parasites dans un circuit hyperfréquence en introduisant, en série avec chaque capacité parasite, une capacité dont le diélectrique est l'air.

Cette capacité à air est obtenue par:

– la suppression localisée de la métallisation du plan de masse porté par la seconde face du substrat, dans le régions correspondant aux plages métallisées portées par la première face du substrat,
– l'introduction d'une lame d'air, dans le régions dépourvues de métallisation du plan de masse, entre le substrat et un second plan de masse formé par le support ou le boîtier métallique du circuit hyperfréquence.

En d'autres termes, les capacités parasites sont diminuées en valeur par éloignement localisé du plan de masse, et interposition entre la région dépourvue de métallisation du substrat et le plan de masse éloigné d'une capacité à air, de très faible valeur, puisque la constante diélectrique de l'air, égale à 1 par définition, est inférieure à la constante diélectrique d'un substrat quel qu'il soit.

De plus un circuit hyperfréquence est généralement rendu solidaire d'un support métallique qui est soit une semelle de fixation dans un ensemble mécanique, soit un boîtier d'encapsulation. Ce support métallique constitue un second plan de masse. Afin de réduire les capacités parasites, le second plan de masse est percé aux emplacements où la métallisation du premier plan de masse est supprimé.

De façon plus précise, l'invention consiste en un circuit hyperfréquence à faibles capacités parasites, comportant un substrat en matériau diélectrique et, sur une première face de ce substrat, au moins une métallisation de report de composant du circuit hyperfréquence et au moins une ligne de connexion de type microbande formée par une piste conductrice et par une métallisation de plan de masse, celle-ci étant sur une deuxième face du substrat, lui-même supporté par une embase métallique d'un boîtier, ce circuit hyperfréquence étant caractérisé en ce que, en vue de diminuer la capacité parasite qui se forme entre la métallisation de report du composant et la métallisation de plan de masse, la deuxième face du substrat comporte une région dépourvue de métallisation, à l'aplomb de la métallisation de report de composant, ladite région étant de dimensions plus importantes que celle de la métallisation de report de composant, et en ce que l'embase du boîtier est éloignée de la région dépourvue de métallisation par une lame d'air ayant une épaisseur supérieure à l'épaisseur de la métallisation de plan de masse et au moins égale à 100 microns.

L'invention sera mieux comprise par la description suivante de deux exemples d'applications, en corrélation avec les figures jointes en annexe, qui représentent:

– figures 1 et 2: vues en plan et en coupe, respectivement, d'un élément de circuit hyperfréquence, comportant des composants communs à tous les circuits hyperfréquences, et montrant la formation des capacités parasites, dans l'art connu,
– figure 3: schéma d'un oscillateur hyperfréquence idéal,
– figure 4: schéma réel de l'oscillateur hyperfréquence de la figure 3, réalisé selon la technologie de la figure 2,
– figure 5: vue en coupe d'un circuit hyperfréquence, comportant un moyen connu pour diminuer la capacité parasite d'un plot de calbage,
– figure 6: vue en coupe d'un circuit hyperfréquence selon l'invention, sous une forme hybride,
– figure 7: vue en coupe d'un circuit hyperfréquence selon l'invention, sous une forme intégrée.

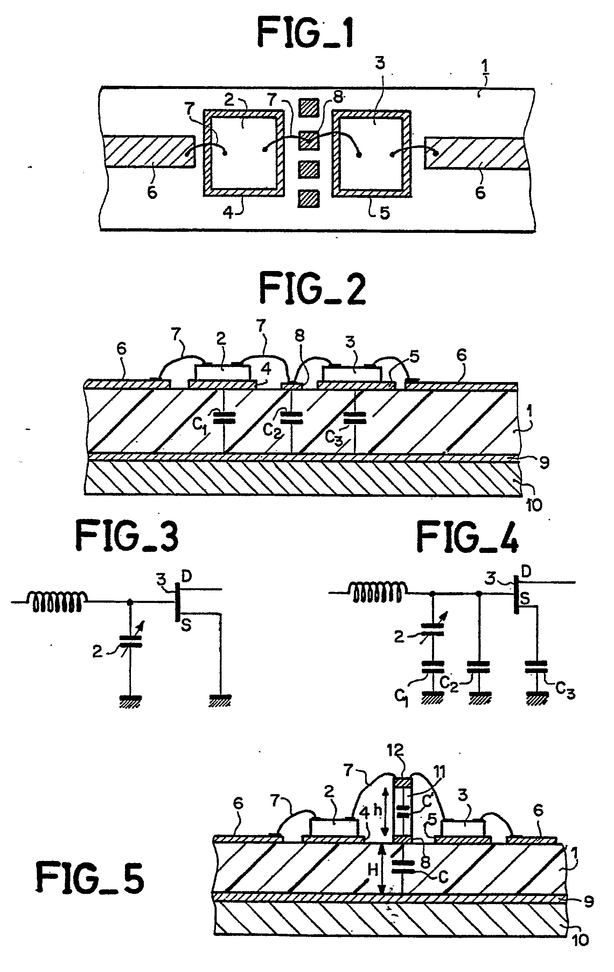

La figure 1 répresente une vue partielle en plan d'un circuit hyperfréquence. Celui-ci comporte un substrat isolant 1, c'est-à-dire en matériau ayant une constante diélectrique qui lui est propre, sur lequel sont rapportés au moins deux composants actif ou passif 2 et 3. La fixation des composants 2 et 3 sur le substrat 1 se fait au moyen de métallisations 4 et 5, qui ont la forme et les dimensions d'encombrement des composants 2 et 3, ce qui permet de souder ou braser les composants sur le substrat. Le réseau d'interconnexion dans un circuit hyperfréquence se fait au moyen de microbandes, connues également sous le nom anglais de micro-strips 6, et la connexion entre l'extrémité d'une microbande et un composant se fait par des fils ou des rubans 7 soudés sur la microbande 6 et sur le composant. De façon à améliorer la fiabilité du circuit, et dans certains cas à raccourcir la longueur des liaisons 7, les circuits hyperfréquences comportent fréquemment des métallisations 8 qui servent de plots de relais pour souder un fil 7 entre deux composants, ou pour accorder l'impédance d'un circuit.

Ce même circuit est représenté en figure 2, en coupe, et on voit sur cette figure 2 que la face arrière, c'est-à-dire la seconde face principale du substrat 1, est très généralement métallisée sur toute sa surface en 9. Cette métallisation 9 constitue un premier plan de masse du circuit hyperfréquence, et elle est nécessaire pour former les microbandes avec les réseaux d'interconnexions 6 qui sont déposés sur la première face principale du substrat. En outre les circuits hyperfréquences sont fréquemment rendus solidaires d'une semelle métallique 10, qui constitue donc un second plan de masse pour le circuit hybride, cette semelle servant soit à fixer le circuit dans un ensemble mécanique plus vaste, soit à constituer le boitier d'encapsulation.

Ainsi il se forme entre les métallisations déposées sur la première face principale du substrat et la métallisation 9 de la seconde face principale du substrat des capacités parasites dont le matériau du substrat diélectrique 1 constitue le diélectrique. Dans le cas d'exemple choisi pour la figure 1, la métallisation 4 d'un premier composant 2 forme avec le plan de masse une première capacité parasite C1, le plot de relais 8 forme avec le plan de masse une seconde capacité parasite C2, et la métallisation 5 du second composant 3 forme avec le plan de masse une troisième capacité parasite C3. En raison des dimensions extrêmement petites de ces métallisations, ces capacités parasites sont négligeables en statique ou en courant continu. Elles ne le sont plus en hyperfréquence, puisque les dimensions changent d'importance en hyperfréquence et que même la longueur des fils ou rubans 7 constitue alors des selfs.

Pour mettre en évidence le rôle néfaste de ces capacités parasites, on peut considérer le cas représenté en figure 3 d'un oscillateur hyperfréquence. Cette figure est réduite à son strict minimum et un varactor 2, qui peut être par exemple le composant 2 des figures 1 et 2, commande un transistor à effet de champ 3, qui peut tout aussi bien être le composant 3 des figures 1 et 2. Sans entrer dans les détails, des selfs permettent d'alimenter cet oscillateur et d'introduire un circuit oscillant sur la grille du transistor à effet de champ 3. Ce schéma est un schéma idéal, mais s'il est réalisé selon la technologie des figures 1 et 2, les capacités parasites C1, C2 et C3 sont introduites et le schéma de la figure 3 devient le schéma réel de la figure 4.

Bien que dans les circuits hyperfréquences, on ait l'habitude de tenir compte des inductances et capacités parasites qui se développent dans ces circuits, la présence d'une capacité parasite telle que C2 correspondant au plot de cablage, est inadmissible puisqu'elle désaccorde le circuit.

Il convient donc de trouver un procédé pour diminuer l'importance des capacités parasites. Un procédé connu actuellement est représenté en figure 5 dans une vue en coupe. Cette figure 5 reprend les mêmes éléments que la figure 2, mais, à titre d'exemple non limitatif, le plot de cablage 8 est remplacé par un pavé de silice fondue 11. Plus exactement, sur la métallisation 8 du plot de cablage est fixé un pavé d'un matériau dont la constante diélectrique est plus faible que celle du substrat. Si par exemple le substrat diélectrique est de l'alumine, de constante diélectrique $\varepsilon_r = 9,8$, le pavé 11 est constitué de silice fondue dont la constante diélectrique est $\varepsilon'_r = 3,9$. L'extrémité 12, de ce pavé de diélectrique 11 est elle-même métallisée et c'est sur la métallisation 12 qu'a lieu le cablage ou relais de cablage des fils ou rubans 7 entre deux composants tels que les composants 2 et 3.

Ce procédé connu est en soi intéressant mais n'apporte pas encore une réduction de la constante diélectrique suffisante, comme le montre le calcul suivant.

Pour une métallisation telle qu'un plot de cablage 8, la capacité qu'il forme avec le substrat et le plan de masse est exprimée en statique par la valeur :

$$C = \frac{\varepsilon_o \varepsilon_r S}{H}$$

dans laquelle $\varepsilon_o$ est la constante diélectrique de l'air, $\varepsilon_r$ est la constante diélectrique du substrat, S est la surface du plot et H est l'épaisseur du substrat.

On pourrait diminuer la valeur de la capacité parasite C en diminuant S et en augmentant H, mais ceci n'est pas possible car la surface du plot S est fixée par les impératifs de montage ou liée à des règles de conception, et l'épaisseur du substrat H est fixée par les impératifs hyperfréquences, substrat diélectrique sur lequel sont gravés d'autres circuits.

Prenons à titre d'exemple non limitatif de l'invention un substrat diélectrique en alumine, d'épaisseur H = 0,4 mm, de constante diélectrique $\varepsilon_r = 9,8$, et un pavé 11 d'épaisseur 0,6 mm, de section carrée de 0,4 mm de côté, en silice fondue de constante diélectrique $\varepsilon'_r = 3,9$. La surface du plot 8 sur lequel est reporté le pavé 11 doit être au minimum de même surface que celui-ci c'est-à-dire $S = (0,4)^2$. Les deux capacités en série C et C', C étant la capacité formée par le plot de métallisation 8 et le plan de masse 9, et C' étant la capacité formée par le pavé 11 et ses deux métallisations 8 et 12, sont équivalentes à une capacité équivalente $C_{eq}$ telle que :

$$\frac{1}{C_{eq}} = \frac{1}{C} + \frac{1}{C'}$$

$$\text{soit} \quad \frac{H+h}{\varepsilon_{eq}} = \frac{H}{\varepsilon_r} + \frac{h}{\varepsilon'_r}$$

dans laquelle h est la hauteur du pavé de silice fondue 11, c'est-à-dire l'épaisseur de matériau diélectrique entre les deux armatures 8 et 12 du condensateur C'.

Ceci donne $\varepsilon_{eq} \simeq 5$, ce qui réduit de façon notable la constante diélectrique initiale, $\varepsilon_r = 9,8$. La capacité équivalente à l'ensemble des deux capacités C et C' en série est dans le rapport

$$\frac{C_{eq}}{C} = 0,2,$$

par rapport à la capacité parasite C : on a donc diminué la capacité parasite C d'un facteur 5. Ce résultat n'est pas toujours suffisant, et il a l'inconvénient, en introduisant un pavé de silice fondue 11, de compliquer le montage, de réduire la fiabilité potentielle du circuit hybride, et de rallonger de façon importante les fils ou rubans de liaisons 7, donc les selfs.

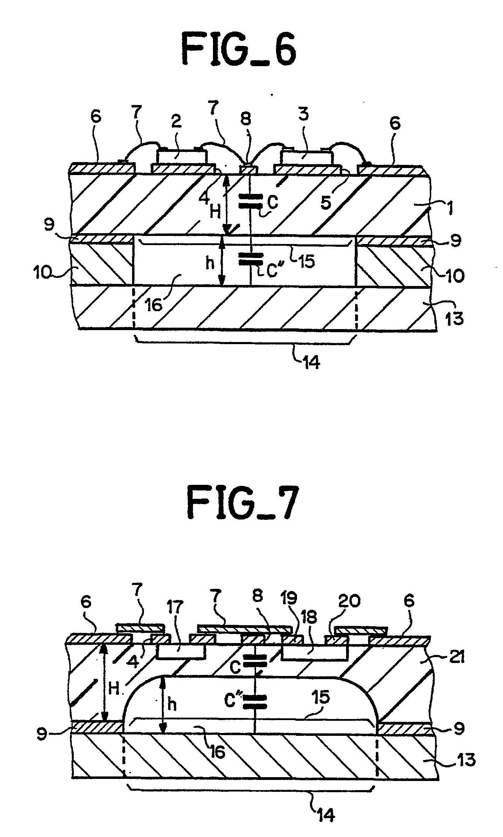

La figure 6 représente une vue en coupe d'un élément de circuit hyperfréquence selon l'invention, dans le premier cas où ce circuit hyperfréquence est réalisé sous forme hybride. De façon à simplifier la compréhension de l'invention et la lecture des dessins, les mêmes indices de repères que sur les précédentes figures sont conservés.

Le circuit hyperfréquence selon l'invention comprend une lame d'air entre le substrat diélectrique du circuit hybride et le plan de masse, de façon à introduire une capacité à air C" en série avec la capacité parasite C.

Pour générer cette lame d'air, l'invention prévoit deux moyens :

- d'abord supprimer, dans chaque région 14 correspondant aux métallisations de la première face principale du substrat qui sont susceptibles de créer des capacités parasites, telles que les métallisations 4, 5 et 8 de la figure 2, une surface 15, équivalente à la région 14, de la métallisation de plan de masse 9 portée par la seconde face principale du substrat, ce qui supprime donc une armature de la capacité parasite C,

- ensuite introduire, en série avec la capacité à diélectrique céramique C, une capacité à air C", de faible valeur, obtenue au moyen d'une lame d'air 16, créée, par exemple, en évidant la partie métallique de la semelle 10, qui constitue un second plan de masse, sur une surface correspondant à la démétallisation 15 pratiquée dans la métallisation de plan de masse 9. Dans le cas le plus général où le circuit hybride est lui-même introduit à l'intérieur d'un boitier dont une partie 13 constitue un nouveau plan de masse, la capacité parasite, qui à l'origine était constituée uniquement par la capacité C, se trouve remplacée par deux capacités en série C et C", avec d'ailleurs la suppression de l'armature intermédiaire puisque la métallisation de plan de masse 9 a été supprimée. Cette démétallisation peut être obtenue de deux façons, soit par masquage et gravure d'un substrat totalement métallisé sur sa face postérieure, pour supprimer le métal qui était en 15, soit au contraire masquage de la région 15 avant dépôt de la métallisation 9.

Dans tous les cas, la région démétallisée 15 est de dimensions plus importantes que celles de la métallisation de report de composant à l'aplomb de laquelle elle se trouve, de façon à éviter les lignes de fuite du champ électrique de la métallisation de report, à travers le substrat.

Bien entendu, la lame d'air 16 doit avoir une épaisseur significative, bien plus importante que la faible épaisseur de la métallisation du plan de masse 9, sinon l'adaptation du circuit hyperfréquence est inefficace. Pour que les résultats soient intéressants, il faut que l'épaisseur de la lame d'air 16 soit du même ordre de grandeur que l'épaisseur H du substrat, et au moins égale à cette épaisseur H, et en tous cas supérieure à 100 microns.

En ce qui concerne la semelle 10 constituant le second plan de masse, le procédé le plus simple, du point de vue de la réalisation industrielle, consiste à opérer un trou circulaire, ce trou pouvant même, dans certains cas, être opéré à travers la paroi du boitier 13, tel que cela est représenté sur la figure 6 par deux lignes en pointillés.

Pour préciser le gain obtenu en introduisant une capacité à air C" en série avec la capacité parasite C, on peut reprendre l'exemple numérique cité à l'occasion de la figure 5, avec un substrat 1 d'alumine rapporté sur une semelle 10 de 0,5 mm d'épaisseur, et percé pour introduire une lame d'air 16. On obtient alors une capacité équivalente donnée par l'expression :

$$\frac{1}{C_{eq}} = \frac{1}{C} + \frac{1}{C''}$$

$$\text{soit} \quad \frac{H+h}{\varepsilon_{eq}} = \frac{H}{\varepsilon_r} + h$$

puisque $\varepsilon_0 = 1$, constante diélectrique de la capacité à air. Ce qui donne $\varepsilon_{eq} = 1,66$. L'introduction d'une capacité à air constituée par l'épaisseur de la semelle métallique 10 réduit la capacité initiale dans le rapport

$$\frac{C_{eq}}{C} = 0,075$$

ce qui réduit en fait la capacité parasite d'un facteur 13.

Bien entendu la capacité C", et la démétallisation en 15 du plan de masse 9, ne sont pas obligatoirement unitaires, c'est-à-dire pratiquées pour chacune des métallisations portées par la première face principale du substrat 1. Ainsi dans le cas de la figure 6, on a conservé la présence côte à côte de deux composants actifs 2 et 3, fixés par l'intermédiaire de leurs métallisations 4 et 5, et un relais de cablage 8. Dans ce cas, du point de vue technologique, il est plus intéressant de considérer l'ensemble des régions susceptibles d'être parasitées par des condensateurs parasites pour les regrouper dans une seule région dans laquelle on introduit une lame d'air 16, pour diminuer ces condensateurs parasites. Ainsi sur la figure 6, aux trois métallisations 4, 5 et 8 ne correspond qu'une seule démétallisation en 15 de la face arrière du substrat et une seule lame d'air 16. Ce qui signifie également que, pour l'ensemble d'un circuit hyperfréquence réel, et non pas simplement pour un élément de circuit tel que représenté en figure 6, le substrat est démétallisé en une pluralité de régions 14, et la semelle est percée par une même pluralité de trous de façon à créer autant de condensateurs à air que de régions 14 sensibles aux condensateurs parasites.

La figure 7 représente une vue en coupe d'un circuit hyperfréquence selon l'invention dans le cas où ce circuit est réalisé sous la forme de circuit intégré, par exemple sur un substrat d'arseniure de gallium semi-isolant.

Dans un substrat d'arseniure de gallium semi-isolant 21 sont réalisés au moins deux composants, par exemple une diode 17 et un transistor à effet de champ 18, pour conserver une comparaison possible avec les quatres figures précédentes. La première surface principale du substrat d'arseniure de gallium supporte des micro-bandes 6, des métallisations de prise de contact 4 sur la diode, 19 et 20 sur le transistor, ainsi que des plots relais 8 soit pour le cablage, soit pour l'accord d'impédance. Selon la forme d'intégration, les contacts électriques entre micro-bandes et transistors ou diodes sont réalisés par des fils ou rubans 7, ou par des métallisations déposées directement sur l'arseniure de gallium et qui mettent en contact les plots de métallisations et de micro-bandes.

L'invention prévoit, afin de diminuer les capacités parasites entre les métallisations précédemment citées et la métallisation 9 de plan de masse portée par la seconde face principale du substrat d'arseniure de gallium, d'introduire une lame d'air, ce qui peut se faire de deux façons. Soit une démétallisation arrière, en 15, du plan de masse 9 et un perçage du boitier dans la région 14. Mais ce procédé est coûteux industriellement car il nécessite l'usinage de trous dans les boitiers métalliques. Par conséquent il est plus avantageux d'opérer une attaque chimique de la face arrière du substrat de façon à introduire dans la région 14 sensible aux capacités parasites une lame d'air 16 qui sépare le substrat mis à nu du métal du boitier 13, qui constitue un nouveau plan de masse. Cette attaque chimique peut se faire selon des procédés connus par masquage et gravure, et elle a l'avantage d'être collective et de se faire sur une rondelle d'arseniure de gallium comportant une pluralité de circuits intégrés, avant découpe des pastilles de circuits intégrés.

Dans le cas d'un circuit hyperfréquence réalisé sous forme intégrée, si l'on admet que H = 0,4 mm pour l'épaisseur de l'arseniure de gallium, h = 0,2 mm comme profondeur d'attaque, et $\varepsilon_r$ = 12,8 pour l'arseniure de gallium, les autres données étant les mêmes que précédemment, le calcul donne $\varepsilon_{eq}$ = 1,80, soit

$$\frac{C_{eq}}{C} = 0,14.$$

On a donc diminué la capacité parasite d'un facteur 7 dans le cas d'un circuit intégré, en admettant que pour ne pas fragiliser le substrat du circuit intégré la profondeur d'attaque h est limitée à la moitié de l'épaisseur du diélectrique.

Bien entendu l'invention n'est pas limitée ni au type de substrat hybride ou intégré qui ont servi à l'exposé de l'invention, ni au cas d'espèce d'une diode et d'un transistor implanté en surface d'un circuit hyperfréquence. L'intérêt du circuit selon l'invention consiste dans le fait que l'on réduit localement les capacités parasites, c'est-à-dire en respectant les adaptations d'impédances des lignes d'entrée et de sortie sous forme de microbandes 6. Un autre intérêt du circuit selon l'invention consiste également dans le fait que son adaptation n'influe pas sur le montage, et le cablage des différents composants du circuit hyperfréquence. Cette adaptation peut même être appliquée sur un circuit existant, essentiellement dans le cas d'un circuit hybride, en démétallisant localement sa face arrière, c'est-à-dire en opérant des ouvertures 15 dans son plan de masse et en perçant la semelle sur laquelle le circuit hybride est monté.

**Revendications**

1. Circuit hyperfréquence à faibles capacités parasites, comportant un substrat (1) en matériau diélectrique et, sur une première face de ce substrat, au moins une métallisation (4, 5, 8) de report de composant (2, 3) du circuit hyperfréquence et au moins une ligne de connexion de type microbande formée par une piste conductrice (6) et par une métallisation de plan de masse (9), celle-ci étant sur une deuxième face du substrat (1), lui-même supporté par une embase métallique (13) d'un boîtier, ce circuit hyperfréquence étant caractérisé en ce que, en vue de diminuer la capacité parasite qui se forme entre la métallisation (4, 5, 8) de report de composant et la métallisation de plan de masse (9), la deuxième face du substrat (1) comporte une région (15) dépourvue de métallisation, à l'aplomb de la métallisation (4, 5, 8) de report de composant, ladite région (15) étant de dimensions (14) plus importantes que celles de la métallisation (4, 5, 8) de report de composant, et en ce que l'embase du boîtier (13) est éloignée de la région (15) dépourvue de métallisation par une lame d'air (16) ayant une épaisseur (h) supérieure à l'épaisseur de la métallisation de plan de masse et au moins égale à 100 microns.

2. Circuit hyperfréquence selon la revendication 1, caractérisé en ce que, dans une forme de circuit hybride sur substrat (1) céramique, l'épaisseur (h) de la lame d'air (16) est au moins égale à l'épaisseur (H) du substrat (1).

3. Circuit hyperfréquence selon la revendication 1, caractérisé en ce que, dans une forme de circuit intégré sur substrat (21) en matériau semiconducteur, l'épaisseur (h) de la lame d'air (16) est au plus égale à la moitié de l'épaisseur (H) du substrat (21).

4. Circuit hyperfréquence selon la revendication 1, caractérisé en ce que, dans une forme de circuit hybride, il est fixé sur une semelle métallique (10), percée dans une région (en 14) correspondant à la région (15) dépourvue de métallisation du plan de masse.

5. Circuit hyperfréquence selon la revendication 1, caractérisé en ce que, dans une forme de circuit intégré, le substrat (21) de ce circuit intégré est creusé dans une région (en 14) correspondant à la région (15) dépourvue de métallisation du plan de masse (9).

6. Circuit hyperfréquence selon la revendication 1, caractérisé en ce que l'embase (13) de son boîtier est percée dans une région (en 14) correspondant à la région (15) dépourvue de métallisation du plan de masse (9).

## Claims

1. A microwave circuit with low parasitic capacities, comprising a substrate (1) of dielectric material and, on a first face of said substrate, at least one metallized area (4, 5 and 8) as a component return means (2 and 3) of the microwave circuit and at least one microband type connection line formed by a conductive track (6) and by a grounding plane metallized area (9), the latter being on a second face of the substrate (1), which is supported by a metallic base (13) of a casing, said microwave circuit being characterized in that with a view to diminishing the parasitic capacity which is formed between the component return metallized area (4, 5 and 8) and the grounding plane metallized area (9), the second face of the substrate (1) comprises a region (15) deprived of metallization, aligned with the component return metallized area (4, 5 and 8), the said region (15) having dimensions (14) larger than those of the component return metallized area (4, 5 and 8) and in that the base of the casing (13) is spaced from the region (15) deprived of metallization by an air layer (16) having a thickness (h) greater than the thickness of the grounding plane metallization and at least equal to 100 microns.

2. The microwave circuit as claimed in claim 1, characterized in that in the form of a hybrid circuit on a ceramic substrate (1) the thickness (h) of the air layer (16) is at least equal to the thickness (H) of the substrate (1).

3. The microwave circuit as claimed in claim 1, characterized in that in the form of an integrated circuit on a substrate (21) of semiconducteur material the thickness (h) of the air layer (16) is at least equal to half the thickness (H) of the substrate (21).

4. The microwave circuit as claimed in claim 1, characterized in that in the form of a hybrid circuit it is secured on a metallic base (10) pierced in a region (at 14) corresponding to the region (15) deprived of metallization of the grounding plane (9).

5. The microwave circuit as claimed in claim 1, characterized in that in the form of an integrated circuit the substrate (21) of such integrated circuit is recessed into a region (at 14) corresponding to the region (15) deprived of metallization of the grounding plane (9).

6. The microwave circuit as claimed in claim 1, characterized in that the base (13) of its casing is pierced in a region (at 14) corresponding to the region (15) deprived of metallization of the grounding plane (9).

## Patentansprüche

1. Hyperfrequenzschaltung mit schwachen parasitären Kapazitäten, mit einem Substrat (1) aus einem dielektrischen Material und, auf einer ersten Seite dieses Substrats, wenigstens einer Metallisierung (4, 5, 8) zum Aufsetzen der Bauteile (2, 3) der Hyperfrequenzschaltung und wenigstens einer Verbindungsleitung von Mikrobandleiterbauart, die aus einer Leiterbahn (6) und aus einer Masseebene-Metallisierung (9) gebildet ist, die sich auf einer zweiten Seite des Substrats (1) befindet, das seinerseits von einem metallischen Sockel (13) eines Gehäuses getragen wird, dadurch gekennzeichnet, daß zur Verringerung der parasitären Kapazität, die sich zwischen der Metallisierung (4, 5, 8) zum Aufsetzen von Bauteilen und der Masseebene-Metallisierung (9) ausbildet, die zweite Seite des Substrats (1) senkrecht unterhalb der Metallisierung (4, 5, 8) zum Aufsetzen von Bauteilen einen Bereich (15) ohne Metallisierung umfaßt, welcher größere Abmessungen (14) als die Metallisierung (4, 5, 8) zum Aufsetzen von Bauteilen aufweist, und daß der Sockel des Gehäuses (13) von dem Bereich (15) ohne Metallisierung durch einen schmalen Luftspalt (16) mit einer Dicke (h), die größer als die Dicke der Masseebene-Metallisierung und mindestens gleich 100 Mikrometer ist, getrennt ist.

2. Hyperfrequenzschaltung gemäß Anspruch 1, dadurch gekennzeichnet, daß in einer Ausgestaltung als Hybridschaltung auf einem Keramiksubstrat (1) die Dicke (h) des schmalen Luftspalts (16) mindestens gleich der Dicke (H) des Substrats (1) ist.

3. Hyperfrequenzschaltung gemäß Anspruch 1, dadurch gekennzeichnet, daß in einer Ausgestaltung als integrierte Schaltung auf einem Substrat (21) aus Halbleitermaterial die Dicke (h) des schmalen Luftspalts (16) höchstens gleich der Hälfte der Dicke (H) des Substrats (21) ist.

4. Hyperfrequenzschaltung gemäß Anspruch 1, dadurch gekennzeichnet, daß sie in einer Ausgestaltung als Hybridschaltung auf einer Metallfußplatte (10) befestigt ist, die in einem dem metallisierungsfreien Bereich (15) der Masseebene (9) entsprechende Bereich (bei 14) durchbohrt ist.

5. Hyperfrequenzschaltung gemäß Anspruch 1, dadurch gekennzeichnet, daß in einer Ausgestaltung als integrierte Schaltung das Substrat (21) dieser integrierten Schaltung in einem dem metallisierungsfreien Bereich (15) der Masseebene (9) entsprechenden Bereich (bei 14) durchbrochen ist.

6. Hyperfrequenzschaltung gemäß Anspruch 1, dadurch gekennzeichnet, daß die Grundfläche (13) ihres Gehäuses in einem dem metallisierungsfreien Bereich (15) der Masseebene (9) entsprechenden Bereich (bei 14) durchbohrt ist.

# FIG_1

# FIG_2

# FIG_3

# FIG_4

# FIG_5

# FIG_6

# FIG_7